# EUROPÄISCHE PATENTSCHRIFT

(11) **EP 3 753 093 B1**
(45) Veröffentlichungstag und Bekanntmachung des Hinweises auf die Patenterteilung: **14.09.2022**
(21) Anmeldenummer: 19700801.4
(22) Anmeldetag: 15.01.2019
(51) Int. Cl.: H02M 1/12, H02H 1/04, H02H 9/00, H02J 3/01

(54) **KOMPENSATIONSFILTER UND VERFAHREN ZUR INBETRIEBNAHME EINES KOMPENSATIONSFILTERS**
COMPENSATION FILTER AND METHOD FOR ACTIVATING A COMPENSATION FILTER
FILTRE DE COMPENSATION ET PROCÉDÉ DE MISE EN SERVICE D'UN FILTRE DE COMPENSATION

(30) Priorität: 15.02.2018 DE 102018103391
(43) Veröffentlichungstag der Anmeldung: 23.12.2020
(73) Patentinhaber: TDK Electronics AG, 81671 München (DE)
(72) Erfinder: KARINCA, Yasin, 89331 Burgau (DE)
(74) Vertreter: Epping - Hermann - Fischer
(86) Internationale Anmeldenummer: PCT/EP2019/050948
(87) Internationale Veröffentlichungsnummer: WO 2019/158295

(56) Entgegenhaltungen:
- EP-A1- 3 255 770
- WO-A1-2014/048471
- DE-A1- 2 854 196
- MARCELO LOBO HELDWEIN ET AL: "Implementation of a Transformerless Common-Mode Active Filter for Offline Converter Systems", IEEE TRANSACTIONS ON INDUSTRIAL ELECTRONICS, IEEE SERVICE CENTER, PISCATAWAY, NJ, USA, Bd. 57, Nr. 5, 1. Mai 2010 (2010-05-01), Seiten 1772-1786, XP011295954, ISSN: 0278-0046
- WENJIE CHEN ET AL: "A Novel Hybrid Common-Mode EMI Filter With Active Impedance Multiplication", IEEE TRANSACTIONS ON INDUSTRIAL ELECTRONICS, IEEE SERVICE CENTER, PISCATAWAY, NJ, USA, Bd. 58, Nr. 5, 1. Mai 2011 (2011-05-01), Seiten 1826-1834, XP011352898, ISSN: 0278-0046, DOI: 10.1109/TIE.2010.2053341

## Beschreibung

Die Erfindung betrifft Kompensationsfilter, die z.B. zur Verringerung von Störungen wie Ableitströmen eingesetzt werden können, und Verfahren zur Inbetriebnahme entsprechender Kompensationsfilter. Ein solches Kompensationsfilter ist zum Beispiel aus der Veröffentlichungsschrift WO2014048471 A1 bekannt.

Aus dem HiFi-Bereich sind Schaltungen bekannt, die den Verstärker zeitverzögert an die Lautsprecher schalten, um den durch Einschwingvorgänge des Verstärkers verursachten Knacks im Lautsprecher zu vermeiden, z.B. DE2854196A1.

Elektrische Verbraucher können mit einer Energiequelle, z.B. einem Stromnetz verschaltet sein. In entsprechenden elektrischen Systemen können Ströme unterschiedlicher Kategorie fließen. Zum einen fließen die üblichen Ströme zum Betreiben des elektrischen Verbrauchers. Zum anderen können unerwünschte Ströme, z.B. Fehlerströme, wenn das Gehäuse mit einer leitenden Phase verbunden ist, entstehen. Diese gefährden die Gesundheit entsprechender Benutzer der elektrischen Verbraucher und müssen verhindert werden. Eine dritte Kategorie bilden Ableitströme. Ein Ableitstrom ist ein elektrischer Strom, der unter üblichen Betriebsbedingungen in einem unerwünschten Strompfad fließt.

Ableitströme stellen dabei eine spezielle Form von Gleichtaktströmen dar. Ableitströme führen in Anlagen mit Fehlerstrom-Schutzschaltern (FI-Schalter), die dazu vorgesehen sind die Gesundheit des entsprechenden Benutzers zu schützen, häufig zu Problemen, da diese den Fehlerstrom-Schutzschalter zum Auslösen bringen können und damit einen zuverlässigen Betrieb stören.

Aus der EP 3113361 A1 sind Schaltungen bekannt, die dazu verwendet werden können, Ableitströme zu verringern.

Aus dem Beitrag: "Implementation of a Transformerless Common-Mode Active Filter for Offline Converter Systems" (Marcelo Lobo Heldwein et al.; IEEE TRANSACTIONS ON INDUSTRIAL ELECTRONICS, IEEE SERVICE CENTER, PISCATAWAY, NJ, USA, Bd. 57, Nr. 5, 1. Mai 2010, Seiten 1772-1786) sind Kompensationsfilter zur Dämpfung von Gleichtaktstörungen bekannt.

Eine weitere Möglichkeit, das Auflösen von Fehlerstrom-Schutzschaltern durch Ableitströme zu verhindern, besteht in der Verwendung von Trenntransformatoren. Das Einsetzen einer Trenntransformators wird häufig durchgeführt, um das Auslösen von Fehlerstrom-Schutzschaltern anhand von statischen Ableitströmen zu verhindern. Die galvanische Trennung führt dazu, dass der Ableitstrom nahezu komplett auf der Sekundärseite des Trenntransformators fließt und somit nicht vom Fehlerstrom-Schutzschalter, der auf der Primärseite sitzt, erfasst wird. Jedoch ist das Einsetzen von Trenntransformatoren aufgrund einiger Nachteile unerwünscht. Die Baugröße nimmt bei höheren Nennströmen signifikant zu, sodass der Trenntransformator groß und schwer wird. Dies kann vor allem z.B. bei mobilen Maschinen ein Ausschlusskriterium sein. Hohe Verlustleistungen und damit verbunden hohe Temperaturen sind weitere Nachteile von Trenntransformatoren.

Eine weitere Möglichkeit besteht darin, eine Netzzuleitung mit einem Festanschluss zu verwenden. Dann kann auf einen Fehlerstrom-Schutzschalter verzichtet werden. Nachteilig hierbei ist allerdings, dass die Anlagen bzw. Maschinen ortsfest sind.

Elektrische Energie kann mit einer Dreiphasenleitung zur Verfügung gestellt werden. Während des Einsteckens der Netzzuleitung an ein 400 V Netz entsteht dabei kurzzeitig eine Netzunsymmetrie, die zur Folge haben kann, dass im Moment des Einsteckens die Sternpunktspannung der kapazitiven Netzanbindung von Null verschieden ist. Dies ist eine weitere Möglichkeit, den Fehlerstrom-Schutzschalter durch einen transienten Ableitstrom zum Auslösen zu bringen.

Es besteht deshalb der Wunsch nach Kompensationsschaltungen, die Gleichtaktstörungen wie z.B. Ableitströme in einer Stromleitung dämpfen und die es ermöglicht, einen elektrischen Verbraucher hinter einem Fehlerstrom-Schutzschalter steckbar zu verwenden.

Diese Aufgabe wird durch die Gegenstände der unabhängigen Ansprüche gelöst. Abhängige Ansprüche geben vorteilhafte Ausgestaltungen an.

Ein Kompensationsfilter hat einen ersten Port, einen zweiten Port und eine Stromleitung zwischen dem ersten Port und dem zweiten Port. Ferner hat das Kompensationsfilter einen elektrischen Verstärker mit einem Eingang und einem Ausgang. Zusätzlich hat das Filter eine Auskoppel-Schaltung, die zwischen der Stromleitung und dem Eingang des Verstärkers verschaltet ist und eine Einkoppel-Schaltung, die zwischen dem Ausgang des Verstärkers und der Stromleitung verschaltet ist. Ferner hat das Kompensationsfilter einen Zeitschalter. Das Kompensationsfilter ist dazu vorgesehen, eine Gleichtaktstörung in der Stromleitung zu dämpfen. Der Zeitschalter ist in Serie zur Einkoppel-Schaltung zwischen dem Ausgang des Verstärkers und der Stromleitung verschaltet.

Das Kompensationsfilter bietet somit die Möglichkeit, Gleichtaktstörungen durch eine Schleife, bestehend aus Auskoppel-Schaltung, Verstärker und Einkoppel-Schaltung zu dämpfen. Eine Störung in der Stromleitung wird über die Auskoppel-Schaltung zumindest teilweise an den Verstärker übermittelt. Der Verstärker gibt ein Kompensationssignal aus, das über die Einkoppel-Schaltung in die Stromleitung eingekoppelt wird. Der Verstärkungsfaktor ist vorzugsweise so, dass zu einem bestimmten Störsignal ein entsprechendes Kompensationssignal der gleichen Frequenz, der gleichen Phasenlage und der gleichen Amplitude aber entgegengesetzten Vorzeichens erzeugt wird.

Der Verstärker kann dabei elektronische Schaltungskomponenten umfassen. So kann der Verstärker beispielsweise einen Operationsverstärker enthalten.

Es wurde erkannt, dass die Verwendung eines entsprechenden Verstärkers Einschwingvorgänge zur Folge hat. D.h. es dauert eine gewisse Zeit, bis der Teilschaltkreis des Kompensationsfilters mit Einkoppel-Schaltung, Verstärker und Auskoppel-Schaltung effektiv funktionieren. Während dieser Zeit können Störungen in der Stromleitung möglicherweise nicht hinreichend stark gedämpft werden. Dadurch, dass der Zeitschalter in Serie zur Einkoppel-Schaltung zwischen dem Ausgang des Verstärkers und der Stromleitung verschaltet ist, besteht die Möglichkeit, den Verstärker erst dann zuzuschalten, d.h. den Schalter zu schließen, wenn Einschwingvorgänge vollendet sind und der Verstärker mit seinen elektronischen Komponenten in gewünschter Weise arbeitet.

Wird ein elektrischer Verbraucher, z.B. mit einer Dreiphasenleitung, über eine Steckverbindung mit einer Energiequelle verschaltet, so besteht die Möglichkeit, unterschiedliche Phasen zu leicht unterschiedlichen Zeitpunkten zu kontaktieren. Die entsprechende Netzunsymmetrie in der Stromleitung hätte dann die Folge, dass im Moment des Einsteckens die Sternpunktspannung der kapazitiven Netzanbindung der aktiven Schaltungskomponenten des Kompensationsfilters von Null verschieden wird. dies würde zu einem hohen transienten Ableitstrom an der Netzanbindung führen, der den Fehlerstrom-Schutzschalter zum Auslösen bringen könnte.

Die Verwendung des Zeitschalters in Serie zur Einkoppel-Schaltung zwischen dem Ausgang des Verstärkers und der Stromleitung unterbindet genau diese von Null verschiedene Sternpunktspannung der Netzanbindung, sodass elektrische Verbraucher, die einen Ableitstrom verursachen steckbar mit einer Energiequelle mit einer Fehlerschutzstromschaltung verwendbar sind.

Es ist dabei möglich, dass die Einkoppel-Schaltung ein kapazitives Element umfasst.

Das kapazitive Element kann dabei durch einen Kondensator mit der Einkoppel-Kapazität Co gebildet sein oder eine entsprechende Einkoppel-Kapazität umfassen.

Für eine einphasige Stromleitung genügt ein einzelner Kondensator als kapazitives Element.

Besteht die Stromleitung aus mehreren Leitern unterschiedlicher Phasenlage, so kann die Einkoppel-Schaltung eine komplexere Schaltungstopologie umfassen. Zumindest der Sternpunkt der Stromleitung ist dabei über zumindest ein kapazitives Element der Einkoppel-Schaltung mit dem Verstärker über dem Zeitschalter koppelbar.

Gleichtaktstörungen können aufgrund ihrer Frequenz kategorisiert werden. Gleichtaktstörungen in einem Frequenzbereich zwischen 50 Hz und einen kHz werden als (quasi) statisch bezeichnet. Variable Störungen, die beispielsweise durch das Takten von Invertern entstehen, haben eine Frequenz zwischen 1 kHz und einigen Kilohertz. Sogenannte transiente Störungen weisen ein breites Frequenzspektrum auf. Solche Störungen entstehen beispielsweise beim Einschalten eines elektrischen Verbrauchers und resultieren im Allgemeinen aus einmaligen, kurzzeitigen Vorgängen.

Eine besondere Bedeutung haben Gleichtaktstörungen einer Frequenz, die der Netzfrequenz der Energiequelle entspricht, z.B. Gleichtaktstörungen mit 50 oder 60 Hz. Diese Störungen sind insofern kritisch, wie sie die Betriebssicherheit des elektrischen Verbrauchers betreffen. Die oben genannten Störungen der zweiten Kategorie haben nämlich im Allgemeinen die Netzfrequenz. Gleichtaktstörungen der Netzfrequenz dürfen durch das Kompensationsfilter nicht gedämpft werden, da bei diesen Störungen der Fehlerstrom-Schutzschalter den elektrischen Verbraucher sofort vom Netz nehmen muss.

Konventionelle Kondensationsschaltungen reagieren dabei im Allgemeinen weniger frequenzselektiv. Aus schaltungstechnischen Gründen ist es bei konventionellen Kompensationsschaltungen vorteilhaft, die Koppelkapazität Co vorzugsweise klein zu wählen.

Um ein sicheres Arbeiten eines Fehlerstrom-Schutzschalters bei einer Netzfrequenz zu gewährleisten, wird deshalb im vorliegenden Kompensationsfilter vorgeschlagen, die Kapazität hinreichend groß zu wählen.

Es ist deshalb möglich, dass die Kapazität Co des kapazitiven Elements der Einkoppel-Schaltung so groß ist, dass Ableitströme auch unterhalb von 1 kHz aber vorzugsweise nicht von der Netzfrequenz kompensiert werden.

Es ist möglich, dass die Auskoppel-Schaltung ein erstes induktives Element und ein zweites induktives Element umfasst. Das zweite induktive Element ist dabei mit dem ersten induktiven Element magnetisch gekoppelt.

Das erste induktive Element kann dabei eine Spule sein oder eine Spule umfassen, die magnetisch mit der Stromleitung oder einem Leiter der Stromleitung gekoppelt oder verschaltet ist. Das zweite induktive Element der Auskoppel-Schaltung ist dabei vorzugsweise direkt oder indirekt mit dem Verstärker verschaltet.

Je nachdem wie groß der Anteil der Leistung ist, die durch die Auskoppel-Schaltung an den Verstärker übermittelt wird, ist der Verstärkungsfaktor des Verstärkers so gewählt, dass das Kondensationssignal, das zurück auf die Stromleitung gegeben wird, vom Betrag so groß ist wie die Störung selbst, damit durch das vom Verstärker bereitgestellte Stromsignal das Störsignal vorzugsweise vollständig kompensiert wird.

Es ist möglich, dass der Verstärker einen Operationsverstärker umfasst, dass ein erstes resistives Element zwischen Einkoppel-Schaltung und dem Ausgang des Verstärkers gekoppelt ist und dass ein zweites resistives Element zwischen der Einkoppel-Schaltung und dem Eingang des Verstärkers verschaltet ist.

Es ist möglich, dass das Kompensationsfilter zu einer Gleichtaktstörung in der Stromleitung ein Kompensationssignal gleicher Frequenz, gleicher Amplitude und umgekehrtem Vorzeichen auf die Stromleitung überträgt.

Es ist entsprechend ferner möglich, dass die Gleichtaktstörung in einem kritischen Frequenzbereich oberhalb einer Netzfrequenz beginnt.

Es ist ferner möglich, dass die Gleichtaktstörung einen Ableitstrom beinhaltet oder aus einem Ableitstrom besteht.

Ferner ist es möglich, dass das Kompensationsfilter eine Versorgungsschaltung für den Verstärker hat.

Die Versorgungsschaltung dient dazu, den Verstärker, d.h. Schaltungskomponenten des Verstärkers, mit elektrischer Leistung zu versorgen. Insbesondere wenn der Verstärker elektronische Schaltungskomponenten wie zum Beispiel Operationsverstärker umfasst, benötigen diese eine elektrische Energieversorgung.

Die Versorgungsschaltung für den Verstärker kann den Verstärker dabei mit einer Spannjung in der Höhe von etwa 48 V Gleichspannung versorgen. Die Versorgungsschaltung kann dabei eine Spannungsquelle mit einem AC/DC-Schaltnetzteil umfassen.

Die Versorgungsschaltung für den Verstärker kann dabei selbst einen eigenen Versorgungseingangsanschluss umfassen. Dieser kann durch Energie aus der Stromleitung oder durch eine externe Energiequelle gespeist werden.

Die Versorgungsschaltung kann zusätzlich oder alternativ auch als Versorgungsschaltung für den Zeitschalter dienen.

Es ist möglich, dass der Zeitschalter ein Relais und eine Ansteuerschaltung für das Relais umfasst.

Es ist möglich, dass die Ansteuerschaltung für das Relais autonom arbeitet. Ein autonomes Arbeiten der Ansteuerschaltung bedeutet dabei, dass keine weiteren Steuer- und Regelleitungen einer externen Schaltungslogik notwendig sind. Die Steuerschaltung nimmt ihre Funktion selbsttätig auf, sobald sie mit einer hinreichend hohen Versorgungsspannung versorgt wird.

Alternativ oder zusätzlich zum Relais kann auch ein Halbleiterschalter Verwendung finden.

Es ist möglich, dass die Ansteuerschaltung mit dem Relais verschaltet ist und einen Energieversorgungs-Anschluss, z.B. für das Relais, hat. Ferner ist es möglich, dass die Ansteuerschaltung ein Serien-RC Glied umfasst.

Das Serien-RC Glied hat dabei zumindest ein resistives und ein kapazitives Element.

Über das resistive Element kann das kapazitive Element aufgeladen oder entladen werden. Die Zeitdauer, die das Aufladen beziehungsweise entladen in Anspruch nimmt, bestimmt dabei im Wesentlichen die zeitliche Verzögerung, nach der der Zeitschalter den Verstärker über die Einkoppel-Schaltung mit der Stromleitung koppelt.

Die Verzögerung des Zeitschalters ist dabei vorzugsweise mindestens so groß, dass Einschwingvorgänge im Verstärker im Wesentlichen abgeschlossen sind und der Verstärker funktionsgemäß arbeitet.

Die Einschwingvorgänge können dabei eine zeitliche Verzögerung von 0,1 s, 0,5 s, 1 s, 1,5 s, 2 s oder 5 s erfordern.

Der Widerstandswert des resistiven Elements und der Kapazitätswert des kapazitiven Elements sind entsprechend gewählt, dass eine kritische Schaltspannung für das Relais erst nach Ablauf der vorgesehenen Verzögerungszeit erreicht wird.

Es ist möglich, dass das resistive Element einen Widerstand von 1,8 kΩ hat, während das kapazitive Element eine Kapazität von 560 mF hat. Das RC-Glied wird dabei von einer Nennspannung in Höhe von 48 V betrieben. Sobald an dem kapazitiven Element eine kritische Spannung von zum Beispiel 33,6 V anliegt, schaltet das angeschlossene Relais und koppelt den Verstärker über die Einkoppel-Schaltung mit der Stromleitung.

Die Ansteuerschaltung kann ferner eine erste Diode, ein zweites resistives Element und eine zweite Diode umfassen.

Die erste Diode kann dabei parallel zum resistiven Element des Serien-RC-Glieds verschaltet sein. Die zweite Diode kann die Elektrode des kapazitiven Elements des RC-Glieds, die mit dem resistiven Element des RC-Glieds verschaltet ist, gegen Masse verschalten. Die zweite Diode kann dabei eine Zenerdiode für eine kritische Spannung von 48 V sein. Damit wird eine Schutzschaltung der Ansteuerschaltung erhalten, sodass Überspannungen gegen Masse abgeleitet werden können.

Die erste Diode dient dazu, eine allzu lange Verzögerung beim Öffnen des Relais zu verhindern, wenn das Kompensationsfilter deaktiviert wird. Sobald die Versorgungsspannung der Ansteuerschaltung wegfällt oder geringer als die Spulenspannung des Relais ist, wird die erste Diode leitend, sodass sich die Ladung des kapazitiven Elements des RC-Glieds schneller über die Diode entladen kann.

Das zweite resistive Element kann als Pull-down-Widerstand dienen, sodass an der Spule des Relais stets ein definierter Spannungswert gegenüber Masse anliegt, wenn die Versorgungsspannung für die Ansteuerschaltung einen nicht definierten Wert annimmt.

Es ist möglich, dass der Zeitschalter dazu vorgesehen ist, den Ausgang des Verstärkers mit der Stromleitung erst nach einer entsprechenden Verzögerung von 0,1 s oder mehr nach Aktivieren des Kompensationsfilters zu koppeln.

Das oben beschriebene Kompensationsfilter ermöglicht es somit, den transienten Ableitstrom an der kapazitiven Netzanbindung während des Einsteckens zu verhindern. Wenn am aktiven Kompensationsfilter keine Phasenspannung anliegt, ist das Relais offen, sodass die Elektronik vom Netz galvanisch getrennt ist. Wenn die Netzzuleitung eingesteckt wird und somit die Phasenspannung am Filter anliegt, wird ab diesem Zeitpunkt das Relais nach zum Beispiel 1,8 s geschlossen, sodass die Elektronik mit dem Netz galvanisch verbunden ist. Da das Relais zeitlich verzögert geschaltet wird, wird sichergestellt, dass keine Netzunsymmetrie mehr vorhanden ist und somit die Sternpunktschaltung bei ca. 0 V gegenüber Masse liegt. Somit wird die Entstehung eines hohen transienten Ableitstroms am aktiven Kompensationsfilter verhindert.

Der Pull-down-Widerstand kann 5,52 kΩ betragen. Das Relais kann eine Ansprechspannung von 33,6 V und eine Rückfallspannung von 4,8 V DC haben. Die Zeitverzögerung wird mittels des RC-Glieds realisiert. Die Dimensionierung der Bauteile ist dabei so gewählt, dass die Zeitverzögerung ungefähr 0,1 s, 0,2 s, 0,5 s, 1 s, 1,5 s, 1,8 s, 2 s oder mehr entspricht. Dabei entspricht die Zeitverzögerung nicht unbedingt einer spezifischen externen Vorgabe, sondern kann empirisch gewählt sein, sodass nach dem Einstecken der Netzzuleitung eine hinreichend lange Zeit vergeht, um eine zuverlässige Inbetriebnahme des Kompensationsfilters zu gewähren.

Bauteiltoleranzen können zu einer geringfügig abweichenden Zeitverzögerung führen. Die Werte sind dabei so zu wählen, dass auch bei toleranzbedingten Abweichungen die Zeitverzögerung ausreichend lang ist.

Ein Verfahren zur Inbetriebnahme eines Kompensationsfilters mit einem Verstärker und einer Stromleitung umfasst dabei zumindest die Schritte:
- Koppeln der Stromleitung mit einer Energiequelle und/oder einem elektrischen Verbraucher,
- Verzögern einer Kopplung zwischen Verstärker und Stromleitung.

Zentrale Aspekte des Kompensationsfilters und Details bevorzugter Ausführungsformen sind in den schematischen Figuren gezeigt.

Es zeigen:
Figur 1 ein Ersatzschaltbild einer einfachen Ausführungsform des Kompensationsfilters,
Figur 2 das Ersatzschaltbild einer Ausführung mit einer Versorgungsschaltung, wobei die Stromleitungen drei Leiter umfasst,
Figur 3 eine einfache Ausführungsform einer Ansteuerschaltung für den Zeitschalter,
Figur 4 typische Spannungsverläufe beim Aktivieren und Deaktivieren der Ansteuerschaltung.

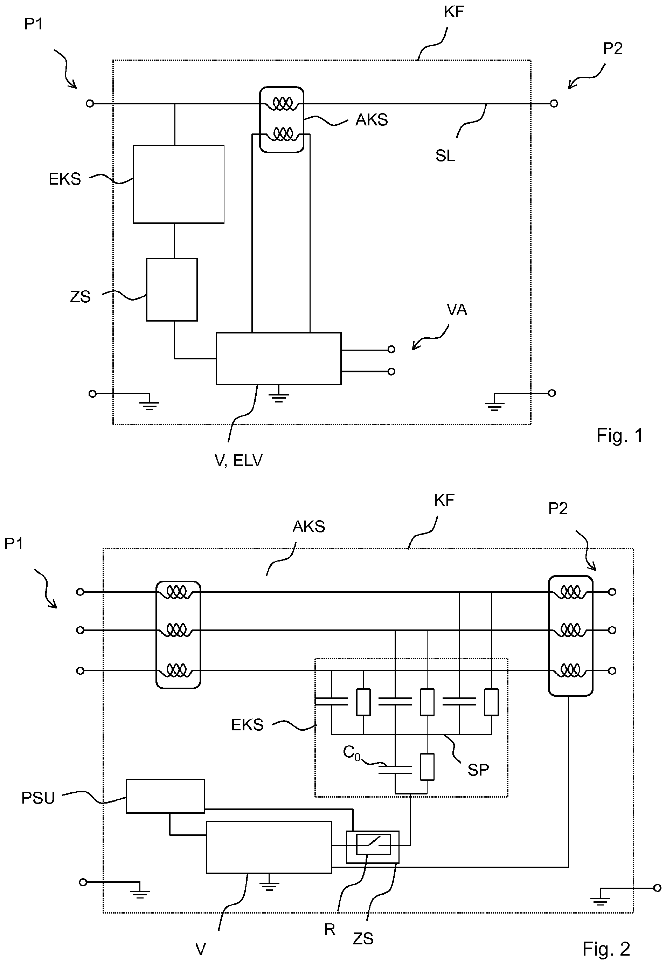

Figur 1 zeigt das Ersatzschaltbild einer einfachen Ausführungsform des Kompensationsfilters KF. Das Kompensationsfilter KF hat einen ersten Port P1 und einen zweiten Port P2. Dazwischen ist eine Stromleitung SL verschaltet. Ferner hat das Kompensationsfilter KF einen Verstärker, zum Beispiel einen elektronischen Verstärker ELV mit elektronischen Schaltungskomponenten, zum Beispiel einem Operationsverstärker. Zwischen der Stromleitung SL und dem Verstärker V ist die Auskoppel-Schaltung AKS verschaltet. Zwischen dem Verstärker V und der Stromleitung SL ist die Einkoppel-Schaltung EKS verschaltet. Zwischen dem Verstärker V und der Einkoppel-Schaltung EKS ist der Zeitschalter ZS verschaltet.

Der Verstärker V kann dabei über einen Versorgungsanschluss VA mit elektrischer Leistung versorgt werden.

Der Zeitschalter ZS dient dazu, das Kompensationssignal, das durch den Verstärker gebildet wird, erst dann über die Einkoppel-Schaltung EKS an die Stromleitung SL zu führen, wenn Einschwingprozesse im Verstärker V abgeschlossen sind und der Verstärker V seine Arbeit vollständig aufgenommen hat.

Die Auskoppel-Schaltung AKS hat dabei gekoppelte induktive Elemente, um elektrische Leistung, die das Störsignal repräsentieren, an den Verstärker V weiterzuleiten.

Figur 2 illustriert die Möglichkeit, Leiter unterschiedlicher Phasen in der Stromleitung SL vorzusehen. Entsprechend zeigt Figur 2 eine Ausführungsform, bei der der Stromleiter SL drei unterschiedliche Leiter hat. Entsprechend besteht der erste Port aus drei individuellen Anschlüssen. Auch der zweite Port P2 hat drei individuelle Anschlüsse. Die Einkoppel-Schaltung EKS hat dabei einen Sternpunkt SP, der idealerweise auf dem gleichen elektrischen Potential wie Masse liegt. Der Sternpunkt SP ist über eine Parallelschaltung eines resistiven Elements und der Koppelkapazität C₀ mit dem Verstärker V gekoppelt. Dazwischen ist der Zeitschalter ZS verschaltet, der ein Relais R oder einen elektronischen Leistungsschalter aufweisen kann. Der Schalter des Zeitschalters ZS wird dabei von einer Ansteuerschaltung gesteuert. Der Zeitschalter ZS und der Verstärker V werden durch eine gemeinsame Versorgungsschaltung PSU mit elektrischer Leistung versorgt. Die Versorgungsschaltung PSU kann dabei ihrerseits von einer externen Energiequelle oder durch Extraktion elektrischer Energie aus der Stromleitung SL mit elektrischer Leistung versorgt werden.

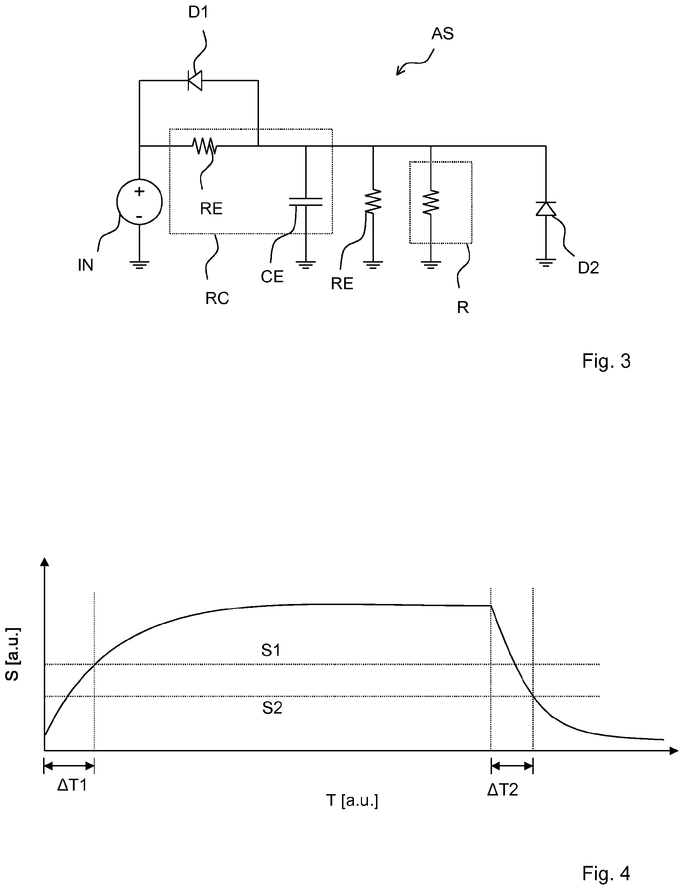

Figur 3 zeigt eine mögliche Topologie einer Ansteuerschaltung AS für das Relais R. Die Ansteuerschaltung AS hat einen Leistungseingang IN und ein RC-Glied RC. Das RC-Glied RC hat ein resistives Element RE und ein kapazitives Element CE, die in Serie verschaltet sind. Wird die Ansteuerschaltung AS aktiviert, so wird das kapazitive Element CE des RC-Glieds RC über das resistive Element RE aufgeladen. Dieses Aufladen bewirkt eine zeitliche Verzögerung, ab der an der Spule des Relais R eine hinreichend hohe Spannung zur Betätigung des Relais anliegt. Ein zweites resistives Element RE dient als Pull-down-Widerstand, um dem Knoten zwischen dem resistiven Element RE und dem kapazitiven Element CE des RC-Glieds RC ein definiertes Potential zuzuweisen, falls die Ansteuerschaltung nicht mit einer definierten Eingangsspannung am Eingang IN beaufschlagt ist.

Die Diode D1 dient dazu, das kapazitive Element CE des RC-Glieds RC schneller zu entladen, wenn die Ansteuerschaltung AS deaktiviert wird. Die Diode D2 dient als Schutzelement zum Schutz der Schaltung, falls eine zu hohe Spannung am Eingang IN anliegt.

Die Spule des Relais R wirkt in der Ansteuerschaltung AS effektiv als resistives Element.

Figur 4 zeigt zeitliche Spannungsverläufe beim Aktivieren und beim Deaktivieren der Ansteuerschaltung AS. Nach einer Zeitspanne ΔT1 nach dem Aktivieren der Ansteuerschaltung AS der Figur 3 ist die Spannung, die am kapazitiven Element CE des RC-Glieds anliegt, so hoch, dass eine erste kritische Spannung S1 erreicht ist. Die Spannung, die dabei an der Spule des Relais R anliegt, reicht ab nun aus, um das Relais zu aktivieren und den Verstärker V mit der Stromleitung SL zu koppeln.

Eine Zeitdifferenz ΔT2 nach dem Deaktivieren der Ansteuerschaltung AS, das heißt nach Entfernen der Spannung am Eingang IN, wird das kapazitive Element CE des RC-Glieds RC über die Diode so weit entladen, dass eine zweite kritische Spannung S2 unterschritten wird, sodass das Relais R die Verbindung zwischen Verstärker V und Stromleitung SL über die Einkoppel-Schaltung EKS wieder trennt.

Durch das Erreichen der Verzögerung ΔT1 beim Aktivieren der Ansteuerschaltung beim Aktivieren des Kompensationsfilters wird dem Verstärker V hinreichend viel Zeit gegeben, um einzuschwingen und die vorgesehene Arbeitsweise zu erreichen.

Insbesondere Störsituationen durch Ableitströme beim Einstecken der Netzzuleitung - wenn der elektrische Verbraucher direkt mit dem zweiten Port verschaltet ist - werden somit verhindert und der elektrische Verbraucher kann an einer Netzzuleitung mit Fehlerstromschaltung sicher betrieben werden.

Das Kompensationsfilter und das Verfahren zur Inbetriebnahme eines Kompensationsfilters sind nicht auf die gezeigten und beschriebenen Ausführungsformen und Details beschränkt. Das Kompensationsfilter kann weitere Schaltungselemente enthalten und das Verfahren kann zusätzliche Verfahrensschritte umfassen.

### Bezugszeichenliste

- AKS: Auskoppel-Schaltung
- AS: Ansteuerschaltung
- Co: Koppelkapazität
- CE: kapazitives Element
- D1: erste Diode
- D2: zweite Diode
- EKS: Einkoppel-Schaltung
- IN: Eingangsanschluss der Ansteuerschaltung
- KF: Kompensationsfilter
- P1: erster Port
- P2: zweiter Port
- PSU: Versorgungsschaltung
- R: Relais
- RC: RC-Glied
- RE: resistives Element
- SL: Stromleitung
- SP: Sternpunkt
- V, ELV: Verstärker, elektronischer Verstärker
- VA: Versorgungsanschluss
- ZS: Zeitschalter

## Patentansprüche

1. Kompensationsfilter (KF) zur Verringerung von Störungen wie Ableitströmen, umfassend
- einen ersten Port (P1), einen zweiten Port (P) und eine Stromleitung (SL) zwischen dem ersten Port (P1) und dem zweiten Port (P2),
- einen elektrischen Verstärker (V, ELV) mit einem Eingang und einem Ausgang,
- eine Auskoppel-Schaltung (AKS), die zwischen der Stromleitung (SL) und dem Eingang des Verstärkers (V, ELV) verschaltet ist,
- eine Einkoppel-Schaltung (EKS), die zwischen dem Ausgang des Verstärkers (V, ELV) und der Stromleitung (SL) verschaltet ist,
- einen Zeitschalter (ZS),
wobei
- das Kompensationsfilter (KF) dazu vorgesehen ist, eine Gleichtaktstörung in der Stromleitung (SL) zu dämpfen und
- der Zeitschalter (ZS) in Serie zur Einkoppel-Schaltung (EKS) zwischen dem Ausgang des Verstärkers (V, ELV) und der Stromleitung (SL) verschaltet ist.

2. Kompensationsfilter (KF) nach dem vorherigen Anspruch, wobei die Einkoppel-Schaltung (EKS) ein kapazitives Element (Co) umfasst.

3. Kompensationsfilter (KF) nach dem vorherigen Anspruche, wobei die Kapazität Co des kapazitiven Elements (Co) so groß ist, dass Ableitströme auch unterhalb von 1 kHz kompensiert werden.

4. Kompensationsfilter (KF) nach einem der vorherigen Ansprüche, wobei die Auskoppel-schaltung (AKS) ein erstes induktives Element und ein zweites induktives Element, das mit dem ersten induktiven Element magnetisch gekoppelt ist, umfasst.

5. Kompensationsfilter (KF) nach einem der vorherigen Ansprüche, wobei
- der Verstärker (V, ELV) einen Operationsverstärker (V, ELV) umfasst,
- ein erstes resistives Element (RE) zwischen Einkoppel-Schaltung (EKS) und dem Ausgang des Verstärkers (V, ELV) gekoppelt ist,
- ein zweites resistives Element (RE) zwischen der Einkoppel-Schaltung (EKS) und dem Eingang des Verstärkers (V, ELV) verschaltet ist.

6. Kompensationsfilter (KF) nach einem der vorherigen Ansprüche, das zu einer Gleichtaktstörung in der Stromleitung (SL) ein Kompensationssignal gleicher Frequenz, gleicher Amplitude und umgekehrtem Vorzeichen auf die Stromleitung (SL) überträgt.

7. Kompensationsfilter (KF) nach einem der vorherigen Ansprüche, wobei die Gleichtaktstörung in einem kritischen Frequenzbereich oberhalb einer Netzfrequenz beginnt.

8. Kompensationsfilter (KF) nach einem der vorherigen Ansprüche, wobei die Gleichtaktstörung einen Ableitstrom beinhaltet.

9. Kompensationsfilter (KF) nach einem der vorherigen Ansprüche, ferner umfassend eine Versorgungsschaltung für den Verstärker (V, ELV) und/oder den Zeitschalter (ZS).

10. Kompensationsfilter (KF) nach einem der vorherigen Ansprüche, wobei der Zeitschalter (ZS) ein Relais (R) und eine Ansteuerschaltung dafür umfasst.

11. Kompensationsfilter (KF) nach dem vorherigen Anspruch, wobei die Ansteuerschaltung für das Relais (R) autonom arbeitet.

12. Kompensationsfilter (KF) nach einem der beiden vorherigen Ansprüche, wobei die Ansteuerschaltung
- mit dem Relais (R) verschaltet ist,
- einen Energieversorgungs-Anschluss (VA) und
- ein Serien-RC Glied umfasst.

13. Kompensationsfilter (KF) nach dem vorherigen Anspruch, wobei die Ansteuerschaltung ferner eine erste Diode (D1), eine zweites resistives Element (RE) und eine zweite Diode (D2) umfasst.

14. Kompensationsfilter (KF) nach einem der vorherigen Ansprüche, wobei der Zeitschalter (ZS) dazu vorgesehen ist, den Ausgang des Verstärkers (V, ELV) mit der Stromleitung (SL) erst nach einer Verzögerung von 0,1 s oder mehr nach Aktivierung des Kompensationsfilters (KF) zu koppeln.

15. Verfahren zur Inbetriebnahme eines Kompensationsfilters (KF) nach einem der Ansprüche 1-14 mit einem Verstärker (V, ELV) und einer Stromleitung (SL), umfassend die Schritte
- Koppeln der Stromleitung (SL) mit einer Energiequelle und/oder einem elektrischen Verbraucher,
- Verzögern einer Kopplung zwischen Verstärker (V, ELV) und Stromleitung (SL).

## Claims

1. Compensation filter (KF) for reducing interference such as leakage currents, comprising
- a first port (P1), a second port (P) and a power supply line (SL) between the first port (P1) and the second port (P2),
- an electrical amplifier (V, ELV) having an input and an output,
- an output-coupling circuit (AKS) connected between the power supply line (SL) and the input of the amplifier (V, ELV),
- an input-coupling circuit (EKS) connected between the output of the amplifier (V, ELV) and the power supply line (SL), and
- a time switch (ZS), wherein
- the compensation filter (KF) is provided to attenuate a common-mode interference in the power supply line (SL), and
- the time switch (ZS) is connected in series with the input-coupling circuit (EKS) between the output of the amplifier (V, ELV) and the power supply line (SL).

2. Compensation filter (KF) according to the preceding claim, wherein the input-coupling circuit (EKS) comprises a capacitive element (C₀).

3. Compensation filter (KF) according to the preceding claims, wherein the capacitance value Co of the capacitive element (Co) is large enough so that even leakage currents below 1 kHz are compensated for.

4. Compensation filter (KF) according to any one of the preceding claims, wherein the output-coupling circuit (AKS) comprises a first inductive element and a second inductive element which is magnetically coupled to the first inductive element.

5. Compensation filter (KF) according to any one of the preceding claims, wherein
- the amplifier (V, ELV) comprises an operational amplifier (V, ELV),
- a first resistive element (RE) is coupled between the input-coupling circuit (EKS) and the output of the amplifier (V, ELV),
- a second resistive element (RE) is connected between the input-coupling circuit (EKS) and the input of the amplifier (V, ELV).

6. Compensation filter (KF) according to any one of the preceding claims, which transmits a compensation signal with the same frequency, the same amplitude and inverse sign to the power supply line (SL) when a common-mode interference occurs in the power supply line (SL).

7. Compensation filter (KF) according to any one of the preceding claims, wherein the common-mode interference starts in a critical frequency range above a grid frequency.

8. Compensation filter (KF) according to any one of the preceding claims, wherein the common-mode interference contains a leakage current.

9. Compensation filter (KF) according to any one of the preceding claims, further comprising a supply circuit for the amplifier (V, ELV) and/or the time switch (ZS).

10. Compensation filter (KF) according to any one of the preceding claims, wherein the time switch (ZS) comprises a relay (R) and an actuating circuit for said relay.

11. Compensation filter (KF) according to the preceding claim, wherein the actuating circuit for the relay (R) works autonomously.

12. Compensation filter (KF) according to any one of the two preceding claims, wherein the actuating circuit
- is connected to the relay (R),
- comprises a power supply connection (VA), and
- a series RC network.

13. Compensation filter (KF) according to the preceding claim, wherein the actuating circuit further comprises a first diode (D1), a second resistive element (RE) and a second diode (D2).

14. Compensation filter (KF) according to any one of the preceding claims, wherein the time switch (ZS) is provided to couple the output of the amplifier (V, ELV) to the power supply line (SL) only after a delay of 0.1 s or more after the compensation filter (KF) is turned on.

15. Method for activating a compensation filter (KF) according to any one of Claims 1-14 having an amplifier (V, ELV) and a power supply line (SL), comprising the steps of:
- coupling the power supply line (SL) to a power source and/or to an electrical load,
- delaying a coupling between the amplifier (V, ELV) and power supply line (SL).

## Revendications

1. Filtre de compensation (KF) pour la diminution de défauts tels que les courants de fuite, comprenant
- un premier port (P1), un deuxième port (P) et un câble électrique (SL) entre le premier port (P1) et le deuxième port (P2),
- un amplificateur électrique (V, ELV) présentant une entrée et une sortie,
- un circuit de déconnexion (AKS), qui est connecté entre le câble électrique (SL) et l'entrée de l'amplificateur (V, ELV),
- un circuit de connexion (EKS), qui est connecté entre la sortie de l'amplificateur (V, ELV) et le câble électrique (SL),
- un temporisateur (ZS), où
- le filtre de compensation (KF) est destiné à atténuer un défaut de mode commun dans le câble électrique (SL) et
- le temporisateur (ZS) est connecté en série avec le circuit de connexion (EKS) entre la sortie de l'amplificateur (V, ELV) et le câble électrique (SL).

2. Filtre de compensation (KF) selon la revendication précédente, le circuit de connexion (EKS) comprenant un élément capacitif (C₀).

3. Filtre de compensation (KF) selon la revendication précédente, la capacité Co de l'élément capacitif (Co) étant telle que les courants de fuite inférieurs à 1 kHz sont également compensés.

4. Filtre de compensation (KF) selon l'une quelconque des revendications précédentes, le circuit de déconnexion (AKS) comprenant un premier élément inductif et un deuxième élément inductif qui est couplé de manière magnétique au premier élément inductif.

5. Filtre de compensation (KF) selon l'une quelconque des revendications précédentes, où
- l'amplificateur (V, ELV) comprend un amplificateur opérationnel (V, ELV),
- un premier élément résistif (RE) est couplé entre le circuit de connexion (EKS) et la sortie de l'amplificateur (V, ELV),
- un deuxième élément résistif (RE) est connecté entre le circuit de connexion (EKS) et l'entrée de l'amplificateur (V, ELV) .

6. Filtre de compensation (KF) selon l'une quelconque des revendications précédentes, qui transmet au câble électrique (SL), suite à un défaut de mode commun dans le câble électrique (SL), un signal de compensation de même fréquence, de même amplitude et de signe inverse.

7. Filtre de compensation (KF) selon l'une quelconque des revendications précédentes, le défaut de mode commun démarrant dans une plage de fréquences critique au-dessus d'une fréquence de réseau.

8. Filtre de compensation (KF) selon l'une quelconque des revendications précédentes, le défaut de mode commun comprenant un courant de fuite.

9. Filtre de compensation (KF) selon l'une quelconque des revendications précédentes, comprenant en outre un circuit d'alimentation pour l'amplificateur (V, ELV) et/ou le temporisateur (ZS).

10. Filtre de compensation (KF) selon l'une quelconque des revendications précédentes, le temporisateur (ZS) comprenant un relais (R) et un circuit de commande pour celui-ci.

11. Filtre de compensation (KF) selon la revendication précédente, le circuit de commande pour le relais (R) fonctionnant de manière autonome.

12. Filtre de compensation (KF)selon l'une quelconque des deux revendications précédentes, où le circuit de commande
- est connecté au relais (R),
- comprend un raccordement d'alimentation en énergie (VA) et
- un élément RC en série.

13. Filtre de compensation (KF) selon la revendication précédente, le circuit de commande comprenant en outre une première diode (D1), un deuxième élément résistif (RE) et une deuxième diode (D2).

14. Filtre de compensation (KF) selon l'une quelconque des revendications précédentes, le temporisateur (ZS) étant conçu pour ne coupler la sortie de l'amplificateur (V, ELV) au câble électrique (SL) qu'après un retard de 0,1 s ou plus après l'activation du filtre de compensation (KF).

15. Procédé de mise en service d'un filtre de compensation (KF) selon l'une quelconque des revendications 1-14 à l'aide d'un amplificateur (V, ELV) et d'un câble électrique (SL), comprenant les étapes de
- couplage du câble électrique (SL) à une source d'énergie et/ou à un consommateur électrique,
- retardement d'un couplage entre l'amplificateur (V, ELV) et le câble électrique (SL).
